# EUROPEAN PATENT SPECIFICATION

(11) **EP 0 497 503 B1**
(45) Date of publication and mention of the grant of the patent: **26.07.1995**
(21) Application number: 92300584.7
(22) Date of filing: 23.01.1992
(51) Int. Cl.: H01L 39/24

(54) **Process for producing single phase TlCaBaCuO thin films**
Verfahren zur Herstellung einphasiger TlCaBaCuO-Dünnschichten
Procédé de fabrication de films minces de type TlCaBaCuO à phase unique

(30) Priority: 29.01.1991 US 647382
(43) Date of publication of application: 05.08.1992
(73) Proprietor: International Business Machines Corporation, Armonk, N.Y. 10504 (US)
(72) Inventor: Lee, Victor Y., San Jose, CA 95120 (US); Lee, Wen Y., San Jose, CA 95120 (US); Salem, Jesse R., Cupertino, CA 95014 (US)
(74) Representative: Burt, Roger James, Dr.

(56) References cited:
- EP-A- 0 447 260
- EP-A- 0 454 489
- IEEE TRANSACTIONS ON MAGNETICS, vol. 27, no. 2, March 1991, pages 1564-1567, New York, US; Lin R.J. et al.: "Effect of Tl-sources on growth of Tl-Ba-Ca-Cu-O films by diffusion process & APPLIED SUPERCONDUCTIVITY CONFERENCE, 24 September 1990, Snowmass, US
- PATENT ABSTRACTS OF JAPAN vol. 14, no. 437 (E-980)19 September 1990& JP-A-21 70 478
- APPLIED PHYSICS LETTERS vol. 56, no. 16, 16 April 1990, NEW YORK, US, pages 1573-1575, Zeng L. et al.: "Preparation of the Tl-Ba-Ca-Cu-O thick film by processing the screen-printed Ba-Ca-Cu-O film in Tl203 vapor"
- APPLIED PHYSICS LETTERS vol. 56, no. 21, 21 May 1990, NEW YORK, US, pages 2135-2137, Liu R.S. et al.: "Formation of superconducting (Tl,Bi)Sr2CaCu2Oy thin films by rf sputtering and thallium diffusion"

## Description

This invention relates to compositions which exhibit superconducting properties at temperatures of 100K and above and, more particularly, to a method for producing single phase, thin films of such compositions.

Bulk superconductors with zero resistance at temperatures as high as 120K have been prepared from oxides of Thallium (Tl), Calcium (Ca), Barium (Ba), and Copper (Cu), using a variety of process conditions. At least four, high T_{c} phases with Tl:Ca:Ba:Cu ratios of 2223 1223, 2122, and 1122 are known to exist. Articles describing the preparation of such bulk superconducting Thallium-based materials can be found as follows: Sheng et al., Nature, Vol. 332, pp. 138-139 (1988); Hazen et al., Physical Review Letters, Vol. 60, No. 16, pp. 1657-1660 (1988); Torardi et al., Science, Vol. 240, pp. 631-633 (1988); Yu et al., Superconductivity, pp. 1-20 (with 6 pages of drawings), April 21, 1988; Ghosh, New Scientists, pp. 28, April, 1988; Ihara et al., Nature, Vol. 334, pp. 510-511; Krantz et al., Solid State Communications, Vol. 69, No. 3, pp. 209-211 (1989); and Liang et al., Applied Physics Letter, 53(15), pp. 1434-1436 (1988). Additionally, US-A-4,870,052 also discloses a method for producing stable, bulk Thallium-based superconductors.

Subsequent to the earliest reported results of obtaining bulk Thallium-containing superconductors, various investigators have proposed methods for producing thin films of such materials. Thallium based films with zero resistance at temperatures in the 96-97K range have been prepared by both multi-target magnetron sputtering and electron beam evaporation. In addition, sequential thermal evaporation has also been reported. Denhoff et al., in Applied Physics Letters, Vol. 54, No. 7, pp. 660-662 (1989) report that films produced by sequential evaporation exhibit rough and porous structures. They also report, as known previously, that the Thallium component is quite volatile and is easily eliminated from the thin film during an anneal treatment. They suggest that Thallium be incorporated into the film subsequently. In US-A-4,900,710, the inventors suggest depositing an alkali metal layer onto the surface for the purpose of improving properties of a high temperature copper oxide superconductor.

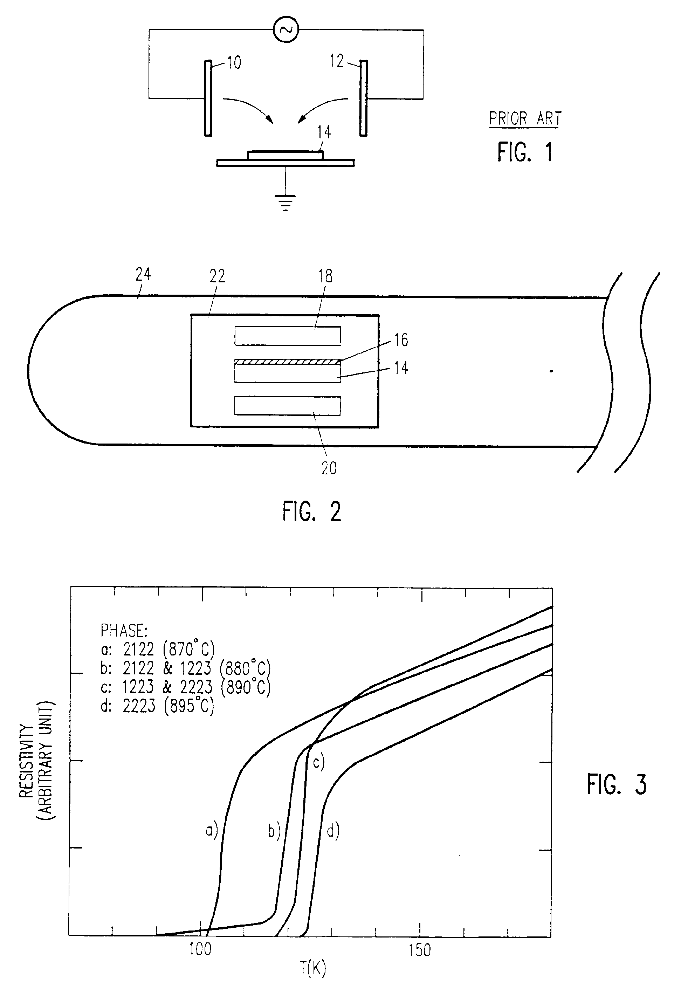

The inventors herein have previously reported, (Applied Physics Letters, 53(4), pp. 329-331 (1988)) the preparation of Thallium-based thin films with a T_{c} as high as approximately 120K. Thallium based films were deposited onto MgO, SrTiO₃ and Yttrium-stabilised ZrO₂ substrates, at ambient temperature, in a symmetrical RF diode sputtering system, using a pair of identical targets. The structure of the deposition system is shown in Fig. 1 and comprises targets 10 and 12, separated by approximately 25 mm., and placed directly opposite one another. A substrate 14 was positioned parallel to the centreline of targets 10 and 12, but outside of the discharge to minimise the often observed resputtering effect.

The as-deposited films were not superconducting, and a post-anneal step at 775-900°C was needed to make them superconduct. Post-annealing of the films was carried out using three different methods: (1) flash annealing in open vessels at 775-800°C, (2) flash annealing in covered alumina crucibles at 900°C for 1-20 minutes and (3) annealing in sealed quartz tubes at 880-900°C for up to 3 hours, with cooling and heating rates in the range of 5-30°C per minute.

Annealing in an open crucible resulted in a substantial loss of Tl from the films and in all cases, a T_{c} well below 100K. The loss of Thallium was considerably reduced by annealing the films in a covered alumina crucible and was further reduced by annealing the films in a sealed quartz tube. In the latter cases, it was found that to produce films with a T_{c} above 100K, that it was necessary to fill the crucible or tube, respectively, with pellets comprised of the same material used for the sputtering target. Nevertheless, it was found that the Thallium content varied widely for the annealing methods disclosed above. It was found, in general, that T_{c} increased with increased Thallium content. Even using pellets comprised of the same material as the sputtering target, gave rise to variations in the Thallium content and to multi-phase containing films.

Viewed from one aspect the present invention provides a method for producing a thin oxide superconductive film comprising constituent elements Tl, Ca, Ba, and Cu, the method comprising the steps of:
a. depositioning a thin amorphous oxide film of the constituent elements on a substrate under ambient conditions;
b. placing a Tl-containing pellet in contact with the thin amorphous oxide film in a sealed environment thereby obtaining a pellet/film layered structure , the T1-containing pellet not previously having been used in a film annealing procedure;
c. subjecting the pellet/film layered structure of step b to an elevated temperature to accomplish an annealing of the thin amorphous film, to produce a single phase of said constituent elements, whereby the T1-containing pellet prevents loss of T1 from the thin film during such anneal.

In order that the invention may be fully understood, a preferred embodiment thereof will now be described, by way of example only, with reference to the accompanying drawings in which:
Fig. 1 is a schematic diagram of a prior art, thin film sputtering system;
Fig. 2 is a schematic diagram of a quartz tube with a sealed insert including superconducting, Thallium-based pellets and a Thallium-based film; and
Fig. 3 is a plot of resistivity vs. temperature for 2223 films deposited as films on MgO and annealed at various temperatures.

As described above, Fig. 1 shows a symmetric, RF diode sputtering system in which Tl₂-Ca₂-Ba₂-Cu₃ oxide targets are employed. The sputtering system deposits an amorphous film comprising the aforesaid composition on a substrate 14. Such deposition preferably occurs at ambient temperature (approx. 45°C), so as to prevent a loss of Thallium and any crystallisation within the film, as it is deposited. Targets 10 and 12, as shown in Fig. 1, are prepared as disclosed in US-A-4,870,052.

Turning to Fig. 2, after a film 16 is deposited onto substrate 14, substrate 14 (and film 16) is sandwiched between a pair of pellets 18 and 20. Each of pellets 18 and 20 is produced using the same method used to produce targets 10 and 12 in Fig. 1. Thus, pellets 18 and 20 comprise bulk-form, high T_{c} phase of T1-Ca-Ba-Cu-O. Each pellet is prepared by annealing a mixture of powder having a 2223 starting composition at 880°C for 3 hours.

Subsequent to placing pellets 18 and 20 about substrate 14, the sandwich structure is wrapped with a gold foil 22. As a result, pellets 18 and 20 are not only tightly held against substrate 14 and film 16, but also foil 22 prevents the dissipation of any Thallium that escapes from either pellets 18, 20, or film 16. In essence, foil 22 provides a contained, Thallium-rich region for film 16 during a subsequent anneal procedure. If desired, only a single pellet may be placed in the sandwich structure, but it must be placed facing thin film 16.

It has been found that a desired, high T_{c} phase of film 16 is not readily obtainable (at least insofar as Thallium content is concerned), unless pellets 18 and 20 have not theretofore been subjected to a film anneal procedure. It is preferred, therefore, that fresh pellets be employed each time a new anneal procedure is carried out. This assures that a single phase film results.

Once the sandwich structure is wrapped by foil 22, it is placed in a quartz tube 24 which is then subsequently filled with oxygen at approximately 1.0 x 10⁵Pa (one atmosphere) and sealed. The quartz tube is then subjected to an anneal procedure in accordance with the below described conditions, for each of the respective phase films.

### EXPERIMENTAL PROCEDURE

Each of the films discussed below were sputter-deposited from a pair of superconducting targets prepared from a 2223 powder mixture, using the symmetrical RF diode sputtering diode system shown in Fig. 1. The targets were prepared using processes disclosed in US-A-4,870,052. Thin films with thicknesses in the range of 0.5-5 »m (microns) were deposited on various substrates, at an ambient temperature of approximately 45°C.

### 2223 FILMS

When an MgO substrate was employed, freshly sintered 2223 pellets were employed and the anneal procedure involved subjecting quartz tube 24 to a temperature of approximately 900°C for approximately 25 minutes. A heating rate of 5°C per minute and a cooling rate of 3°C per minute was employed. The sealed quartz tube reduced Thallium loss, and the gold foil and included pellets maintained a sufficient Thallium pressure nearby the sample, during annealing, to assure that a single phase film was achieved. When a similar film was emplaced on ZrO₂ or LaAlO₃ substrates with freshly sintered 2223 pellets, an anneal temperature of approximately 900°C could be maintained for anywhere from 45 minutes to 10 hours and still obtain the desired single phase 2223 film. A preferred time of application was 2.5 hours. The latter substrates enabled substantially higher heating and cooling rates to be used, with the preferred rate being 30°C per minute. When that heating rate was reduced substantially, a mixed phase was found in the resulting film. It was further found that single phase films on a LaAlO₃ substrate could be made to exhibit a better morphology than either of the films deposited on MgO or ZrO₂. This was achieved by initially annealing the LaAlO₃ substrate in a water-containing oxygen flow at 900°C for two hours, and subsequently depositing the film thereon.

### 2122 FILMS

As with the procedure for the preparation of a 2223 phase film, this procedure also made use of 2223 pellets. In this case, however, it was found that, when an MgO substrate was employed, that anneal conditions required application of a temperature of approximately 875° or less, for approximately 15 minutes. For ZrO₂ and LaAlO₃ substrates, the preferred anneal temperature range was between 810°C and 875°C, applied for approximately 30 minutes. Similar heating and cooling rates to that above disclosed to achieve 2223 phase films for the respective substrate, were employed to achieve the 2122 phase films.

### 1223 FILMS

The procedures required to produce a 1223 phase high T_{c}, film were identical to that described for the 2223 phase film, except that pellets 18 and 20 consisted of bulk 1223 phase materials.

In Fig. 3, a plot is shown of resistivity vs. temperature for 2223 films, deposited on MgO and annealed at (a) 870°C, (b) 880°C and (c) 890°C for 15 minutes, and (d) 895°C for 20 minutes with heating and cooling rates of 5°C and 3°C per minute respectively. It can be seen that curve d provides the highest T_{c} for a 2223 film, after anneal.

The above procedure describes a series of T1-based superconducting film deposition and anneal procedures for the preparation of single phase, 2223, 1223, and 1222 films, on a variety of substrates. The films were sputtered at ambient temperature in a facing target, sputtering configuration and were annealed in a sealed quartz tube with the film wrapped in a gold foil with fresh pellets surrounding.

The resulting films were single phase, stable, and exhibited high Tc's in excess of 100K.

A method for producing high T_{c}, Thallium based films has been described. The method is for producing high Tc-Thallium based superconducting films wherein the Thallium content is closely controllable. The method produces Thallium-based superconducting films which exhibit single phase high T_{c} characteristics.

A method for producing a high T_{c} thin oxide film comprising constituent elements of Tl, Ca, Ba, and Cu has been described. The method comprises the steps of: depositing an oxide film containing said constituent elements as a thin amorphous film on a supporting substrate, under ambient conditions, so that the Tl component is not lost due to elevated temperatures; juxtaposing the thin amorphous layer to a Tl-containing pellet in a sealed environment, the Tl-containing pellet not previously having been subjected to a film annealing procedure; and annealing the thin amorphous film by heating it to produce a single phase of the constituent elements, such phase exhibiting a high T_{c}, whereby the Tl-containing pellet prevents loss of Tl constituents from the thin film.

## Claims

1. A method for producing a thin oxide superconductive film comprising constituent elements Tl, Ca, Ba, and Cu, the method comprising the steps of:
a. depositing a thin amorphous oxide film of the constituent elements on a substrate under ambient conditions;
b. placing a T1-containing pellet in contact with the thin amorphous oxide film in a sealed environment thereby obtaining a pellet/film layered structure , the T1-containing pellet not previously having been used in a film annealing procedure;
c. subjecting the pellet/film layered structure of step b to an elevated temperature to accomplish an annealing of the thin amorphous film, to produce a single phase of said constituent elements, whereby the Tl-containing pellet prevents loss of Tl from the thin film during such anneal.

2. A method as claimed in claim 1 wherein the pellet/film layered structure recited in step b is intimately surrounded by a Tl-impervious enclosing means.

3. A method as claimed in claim 2 wherein the enclosing means comprises a gold foil.

4. A method as claimed in any of claims 2 or 3 wherein the enclosed pellet/film layered structure is placed in a glassy tube having an internal oxygen pressure of approximately 1.0 x 10⁵Pa (one atmosphere).

5. A method as claimed in any of the preceding claims wherein the substrate is comprised of MgO and the Tl-containing pellet is prepared from a starting powder mixture of said constituent elements in the ratio of 2223.

6. A method as claimed in claim 5 wherein step c comprises subjecting the pellet/film layered structure to a temperature of 900°C for approximately 25 minutes and employs a heating rate of approximately 5°C per minute and a cooling rate of approximately 3°C per minute.

7. A method as claimed in any of claims 1 to 4 wherein the substrate comprises ZrO₂ or LaAlO₃, and the Tl-containing pellet is prepared from a starting powder mixture of the constituent elements in the ratio of 2223.

8. A method as claimed in claim 7 wherein the substrate comprises LaAlO₃ and is annealed at approximately 900°C for two hours in a water-containing oxygen flow, prior to deposition of the film.

9. A method as claimed in claim 7 wherein step c comprises subjecting the pellet/film layered structure to a temperature of approximately 900°C for a period of from 45 minutes to 10 hours and employs a heating and cooling rate of approximately 30°C per minute.

10. A method as claimed in claim 5 wherein step c comprises subjecting the pellet/film layered structure to a temperature of approximately 875°C for approximately 15 minutes and employs a heating rate of approximately 5°C per minute and a cooling rate of approximately 3°C per minute.

11. A method as claimed in claim 7 wherein step c comprises subjecting the pellet/film layered structure to a temperature in the range of 810°C to 875°C for approximately 30 minutes.

12. A method as claimed in any of claims 1 to 4 wherein the substrate is comprised of MgO and the Tl-containing pellet exhibits a single phase of the constituent elements in the ratio of 1223.

13. A method as claimed in claim 12 wherein step c comprises subjecting the pellet/film layered structure to a temperature of 900°C for approximately 25 minutes and employs a heating rate of approximately 5°C per minute and a cooling rate of approximately 3°C per minute.

14. A method as claimed in claim 1 wherein the substrate comprises ZrO₂ or LaAlO₃, and the Tl-containing pellet exhibits a single phase of the constituent elements in the ratio of 1223.

15. A method as claimed in claim 14 wherein step c comprises subjecting the pellet/film layered structure to a temperature of approximately 900°C for a period of from 45 minutes to 10 hours and employs a heating and cooling rate of approximately 30°C per minute.

16. A method as claimed in claim 1 wherein the depositing step (a) is accomplished by a sputtering apparatus including opposed superconducting targets, each said target prepared from a mixture of the constituent elements in the ratio 2223.

## Patentansprüche

1. Ein Verfahren zur Herstellung einer dünnen supraleitenden Oxidschicht, welche die Bestandselemente Tl, Ca, Ba und Cu enthält, wobei das Verfahren folgende Schritte umfaßt:
a. Aufbringen einer dünnen amorphen Oxidschicht der Bestandselemente auf einem Substrat unter Umgebungsbedingungen;
b. Anordnen eines Tl enthaltenden Pellets in Kontakt mit der dünnen amorphen Oxidschicht in einer versiegelten Umgebung, wodurch man eine Lagenstruktur Pellet/Schicht erhält, wobei das Tl enthaltende Pellet vorher nicht in einem Schicht-Wärmebehandlungsverfahren verwendet wurde;
c. Die Lagenstruktur Pellet/Schicht aus Schritt b wird einer erhöhten Temperatur ausgesetzt, um eine Wärmebehandlung der dünnen amorphen Schicht zu erreichen, zur Erzeugung einer einzigen Phase der genannten Bestandselemente, wodurch das Tl enthaltende Pellet den Verlust von Tl aus der Dünnschicht während der Wärmebehandlung verhindert.

2. Ein Verfahren nach Anspruch 1, bei dem die Lagenstruktur Pellet/Schicht, auf die in Schritt b verwiesen wurde, eng umgeben ist von einem für Tl undurchdringlichen Umschließungsmittel.

3. Ein Verfahren nach Anspruch 2, bei dem das Umschließungsmittel eine Goldfolie umfaßt.

4. Ein Verfahren nach jedem der Ansprüche 2 oder 3, bei dem die umschlossene Lagenstruktur Pellet/Schicht in eine Glasröhre eingelegt wird, in der ein innerer Sauerstoffdruck von etwa 1,0 x 10⁵ Pa (eine Atmosphäre) herrscht.

5. Ein Verfahren nach jedem der vorangehenden Ansprüche, bei dem das Substrat aus MgO besteht und das Tl enthaltende Pellet aus einer Ausgangspulvermischung der genannten Bestandselemente im Verhältnis 2223 hergestellt wird.

6. Ein Verfahren nach Anspruch 5, bei dem in Schritt c die Lagenstruktur Pellet/Dünnschicht etwa 25 Minuten einer Temperatur von 900°C ausgesetzt wird und eine Aufheizgeschwindigkeit von etwa 5°C pro Minute und eine Abkühlgeschwindigkeit von etwa 3°C pro Minute angewendet wird.

7. Ein Verfahren nach jedem der Ansprüche 1 bis 4, bei dem das Substrat ZrO₂ oder LaAlO₃ umfaßt, und das Tl enthaltende Pellet aus einer Ausgangspulvermischung der Bestandselemente im Verhältnis 2223 hergestellt wird.

8. Ein Verfahren nach Anspruch 7, bei dem das Substrat LaAlO₃ umfaßt und bei etwa 900°C zwei Stunden in einem wasserhaltigen Sauerstoffstrom wärmebehandelt wird, bevor die Dünnschicht aufgetragen wird.

9. Ein Verfahren nach Anspruch 7, bei dem in Schritt c die Lagenstruktur Pellet/Schicht 45 Minuten bis 10 Stunden einer Temperatur von etwa 900°C ausgesetzt wird und eine Aufheiz- und Abkühlgeschwindigkeit von etwa 30°C pro Minute angewendet wird.

10. Ein Verfahren nach Anspruch 5, bei dem in Schritt c die Lagenstruktur Pellet/Schicht etwa 15 Minuten einer Temperatur von etwa 875°C ausgesetzt wird und eine Aufheizgeschwindigkeit von etwa 5°C pro Minute und eine Abkühlgeschwindigkeit von etwa 3°C pro Minute angewendet wird.

11. Ein Verfahren nach Anspruch 7, bei dem in Schritt c die Lagenstruktur Pellet/Schicht etwa 30 Minuten einer Temperatur im Bereich 810°C bis 875°C ausgesetzt wird.

12. Ein Verfahren nach jedem der Ansprüche 1 bis 4, bei dem das Substrat aus MgO besteht und das Tl enthaltende Pellet eine einzige Phase der Bestandselemente im Verhältnis 1223 aufweist.

13. Ein Verfahren nach Anspruch 12, bei dem in Schritt c die Lagenstruktur Pellet/Schicht etwa 25 Minuten einer Temperatur von 900°C ausgesetzt wird und eine Aufheizgeschwindigkeit von etwa 5°C pro Minute und eine Abkühlgeschwindigkeit von etwa 3°C pro Minute angewendet wird.

14. Ein Verfahren nach Anspruch 1, bei dem das Substrat ZrO₂ oder LaAlO₃ umfaßt und das Tl enthaltende Pellet eine einzige Phase der Bestandselemente im Verhältnis 1223 aufweist.

15. Ein Verfahren nach Anspruch 14, bei dem in Schritt c die Lagenstruktur Pellet/Schicht 45 Minuten bis 10 Stunden einer Temperatur von etwa 900°C ausgesetzt wird und eine Aufheiz- und Abkühlgeschwindigkeit von etwa 30°C pro Minute angewendet wird.

16. Ein Verfahren nach Anspruch 1, bei dem der Beschichtungsschritt (a) durch einen Sputterapparat erreicht wird, der einander gegenüberliegende supraleitende Targets enthält, wobei jedes der genannten Targets aus einer Mischung der Bestandselemente im Verhältnis 2223 hergestellt wird.

## Revendications

1. Procédé de production d'un film super-conducteur d'oxyde mince comprenant les éléments T1, Ca, Ba et Cu, le procédé comprenant les étapes suivantes :
a) dépôt d'un film mince d'oxyde amorphe comprenant lesdits éléments constitutifs sur un substrat, sous conditions ambiantes ;
b) mise d'une boulette contenant T1 en contact avec le film d'oxyde mince amorphe dans un environnement scellé obtenant ainsi une structure boulette/film en couche, la boulette contenant du T1 n'ayant pas été utilisé auparavant dans un processus de recuit de film ;
c) soumission de la structure en couche boulette/film en couche de l'étape b à une élévation de température pour réaliser un recuit du film amorphe mince, de manière à réaliser une construction unique desdits éléments constitutifs, ce par quoi la boulette contenant Tl empêche les pertes de T1 du film mince durant ledit recuit.

2. Procédé selon la revendication 1 dans lequel la structure boulette/film en couche de l'étape b est intimement entourée d'un enclos imperméable T1.

3. Procédé selon la revendication 2 dans lequel l'enclos comprend une feuille d'or.

4. Procédé selon l'une quelconque des revendications 2 ou 3 dans lequel la structure en couche boulette/film en couche enclose est placée dans un tube de verre où règne une pression interne d'oxygène d'environ 1.0 x 10⁵Pa (une atmosphère).

5. Procédé selon l'une quelconque des revendications précédentes dans lequel le substrat comprend du MgO et la boulette contenant T1 est préparée à partir d'une mixture en poudre desdits éléments constitutifs dans un rapport de 2223.

6. Procédé selon la revendication 5 dans lequel l'étape c comprend la soumission de la structure boulette/film en couche à une température de 900°C durant 25 minutes environ et utilise un cycle de chauffage évoluant d'environ 5°C par minute et un cycle de refroidissement évoluant d'environ 3°C par minute.

7. Procédé selon l'une quelconque des revendications 1 à 4 dans lequel le substrat comprend ZrO₂ ou LaAlO₃, et la boulette contenant du T1 est préparée à partir d'un mélange en poudre des différents éléments constitutifs dans un rapport de 2223.

8. Procédé selon la revendication 7 dans lequel le substrat comprend LaAlO₃ et est recuit à environ 900°C durant deux heures dans un flot d'oxygène aqueux, avant le dépôt du film.

9. Procédé selon la revendication 7 dans lequel l'étape c comprend la soumission de la structure boulette/film en couche à une température d'environ 900°C durant une période de 45 minutes à 10 heures et utilisant un taux de chauffage et de refroidissement évoluant d'environ 30°C par minute.

10. Procédé selon la revendication 5 dans lequel l'étape c comprend la soumission de la structure boulette/film en couche à une température d'environ 875°C durant une période approximative de 15 minutes et utilise un taux de chauffage évoluant d'environ 5°C par minute et un taux de refroidissement d'environ 3°C par minute.

11. Procédé selon la revendication 7 dans lequel l'étape c comprend la soumission de la structure boulette/film en couche à une température se situant dans la gamme de 810°C à 875°C durant environ 30 minutes.

12. Procédé selon l'une quelconque des revendications 1 à 4 dans lequel le substrat comprend du MgO et la boulette contenant du T1 apparaît selon une phase unique des éléments constitutifs dans un rapport 1223.

13. Procédé selon la revendication 12 dans lequel l'étape c comprend la soumission de la structure boulette/film en couche à une température de 900°C durant environ 25 minutes et utilise un taux d'évolution de chauffage d'environ 5°C par minute et un taux de refroidissement évoluant d'environ 3°C par minute.

14. Procédé selon la revendication 1 dans lequel le substrat comprend du ZrO₂ ou LaAlO₃, et la boulette contenant T1 évolue en phase unique des éléments constituants dans un rapport 1223.

15. Procédé selon la revendication 14 dans lequel l'étape c comprend la soumission de la structure boulette/film en couche à une température d'environ 900°C durant une période de 45 minutes à 10 heures et emploie un taux d'évolution de chauffage et de refroidissement d'environ 30°C par minute.

16. Procédé selon la revendication 1 dans lequel l'étape de dépôt (a) est réalisée par un dispositif de pulvérisation incluant des cibles opposées super-conductrices, chacune desdites cibles étant préparée à partir d'un mélange des éléments constitutifs dans un rapport de 2223.
